Europäisches Patentamt

European Patent Office

Office européen des brevets

(19)

(11) Publication number: **0 231 941 B1**

# (12) EUROPEAN PATENT SPECIFICATION

(45) Date of publication of patent specification: 18.09.91

(51) Int. Cl.⁵: **G06F 7/02**, G01N 21/88, G01N 21/91, G01N 21/84, G01R 31/28

(21) Application number: 87101522.8

(22) Date of filing: 05.02.87

(54) **Method for inspection of printed circuit board assembly by arithmetic comparison of several pictures in different colours.**

(30) Priority: 05.02.86 JP 23292/86

(43) Date of publication of application:
12.08.87 Bulletin 87/33

(45) Publication of the grant of the patent:
18.09.91 Bulletin 91/38

(84) Designated Contracting States:
AT BE CH DE ES FR GB GR IT LI LU NL SE

(56) References cited:
DE-A- 3 422 395
GB-A- 2 139 754
US-A- 3 976 383
US-A- 4 330 712

JEE JOURNAL OF ELECTRONIC EN-
GINEERNG, vol. 16, no. 15, July 1979, pages
60-63, Tokyo, JP; M. MINAMI: "Toshiba's MDI
equipment enhances LSI mask inspecton"

(73) Proprietor: OMRON TATEISI ELECTRONICS
CO.
10, Tsuchido-cho Hanazono Ukyo-ku
Kyoto-shi Kyoto-fu(JP)

(72) Inventor: Kobayashi, Shigeki Omron Tateisi
Electronics Co.
Patent Department 20, Igadera
Shimo-Kaiinji Nagaokakyo-City Kyoto 617(JP)
Inventor: Tateisi, Yoshio Omron Tateisi Elec-
tronics Co.
Patent Department 20, Igadera
Shimo-Kaiinji Nagaokakyo-City Kyoto 617(JP)
Inventor: Yagawa, Toshio Omron Tateisi Elec-
tronics Co.
Patent Department 20, Igadera
Shimo-Kaiinji Nagaokakyo-City Kyoto 617(JP)
Inventor: Utsunomiya, Shunji Omron Tateisi
Electronics Co.
Patent Department 20, Igadera
Shimo-Kaiinji Nagaokakyo-City Kyoto 617(JP)

PATENT ABSTRACTS OF JAPAN, vol. 6, no. 125 (P-127)[1003], 10th July 1982, & JP - A - 57 050 645 (HITACHI SEISAKUSHO K.K.) 25-03-1982

PATENT ABSTRACTS OF JAPAN, vol. 8, no. 23 (P-251)[1460], 31th January 1984; & JP - A - 58 179 343 (NIPPON DENKI K.K.) 20th October 1983

Inventor: **Takahara, Hideaki Omron Tateisi Electronics Co.**
**Patent Department 20, Igadera**
**Shimo-Kaiinji Nagaokakyo-City Kyoto 617(JP)**

(74) Representative: **WILHELMS, KILIAN & PART- NER Patentanwälte**
**Eduard-Schmid-Strasse 2**
**W-8000 München 90(DE)**

## Description

### BACKGROUND OF THE INVENTION

The present invention relates to a method for inspection of printed circuit board assemblies which checks such printed circuit board assemblies for any omissions or mis-placements of component parts mounted thereon by processing a picture image thereof, and more particularly relates to such a method for inspection of printed circuit board assemblies, wherein an arithmetic operation is performed upon a plurality of pictures taken in different colors of such printed circuit board assemblies.

In the prior art, there have been proposed various types of method for inspection of printed circuit board assemblies. That is to say, when an automatic printed circuit board component mounting machine is used for mounting various component parts such as micro chips, other semiconductor devices, resistors, capacitors, and the like to an empty or bare printed circuit board in order to prepare a printed circuit board assembly ready for suffering a soldering process it is possible that in an individual instance not all the component parts will be properly assembled to the bare printed circuit board according to the required arrangement therefor. Therefore an inspection or checking process is required to be performed for verifying that all the component parts are properly assembled to the bare printed circuit board, after such an automatic printed circuit board component mounting machine has completed its job of thus mounting the various component parts to said bare printed circuit board, so as to ensure that all of the components are indeed mounted to the bare printed circuit board at correct positions thereon and in their correct orientations, and for verifying that there is no omission of any such component parts. And, if such an inspection process is conducted manually by a human operator, it is not possible to completely eliminate the possibility of error, and further the speed of inspection is necessarily slow, thus hindering productivity and raising final cost of the assembly.

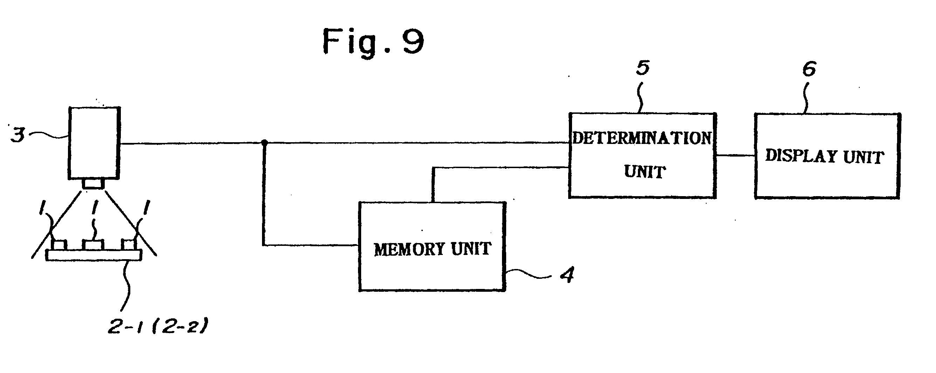

Accordingly, lately, various types of automatic printed circuit board assembly inspection machine have been proposed for performing such an inspection process automatically. Now, an exemplary such prior art automatic printed circuit board assembly inspection machine, and the method of inputting reference printed circuit board assembly data thereto and the method of subsequent operation of said automatic printed circuit board assembly inspection machine, will be explained with regard to Figs. 9 through 11 of the appended drawings.

In Fig. 9, there is shown an automatic printed circuit board assembly inspection machine according to the prior art, which comprises: a TV camera 3 for forming an image of a reference printed circuit board assembly 2-1 or of a subject printed circuit board assembly 2-2, on which component parts designated as 1 are mounted; a memory unit 4 for storing the image produced by this TV camera 3, as well as reference printed circuit board data, or in other words the specification of the correct numbers, types, positions, and orientations of the component parts to be fitted to empty printed circuit boards to constitute the printed circuit board assemblies 2-2 which are required to be checked and inspected (the so called "subject" printed circuit board assemblies), as well as basic data relating to the type of subject printed circuit board assemblies 2-2 which are to be processed and also data relating to the inspection procedure which is to be employed; a determination circuit 5 for comparing the data stored in the storage unit 4 with the data which are indicated by the picture transmitted by the TV camera 3 and for determining whether or not agreement exists therebetween, in other words whether or not all the parts 1 are indeed correctly fitted to the subject printed circuit board assembly 2-2 in the appropriate positions and orientations; and a display unit 6 for displaying the results of the determination thus made by the determination circuit 5.

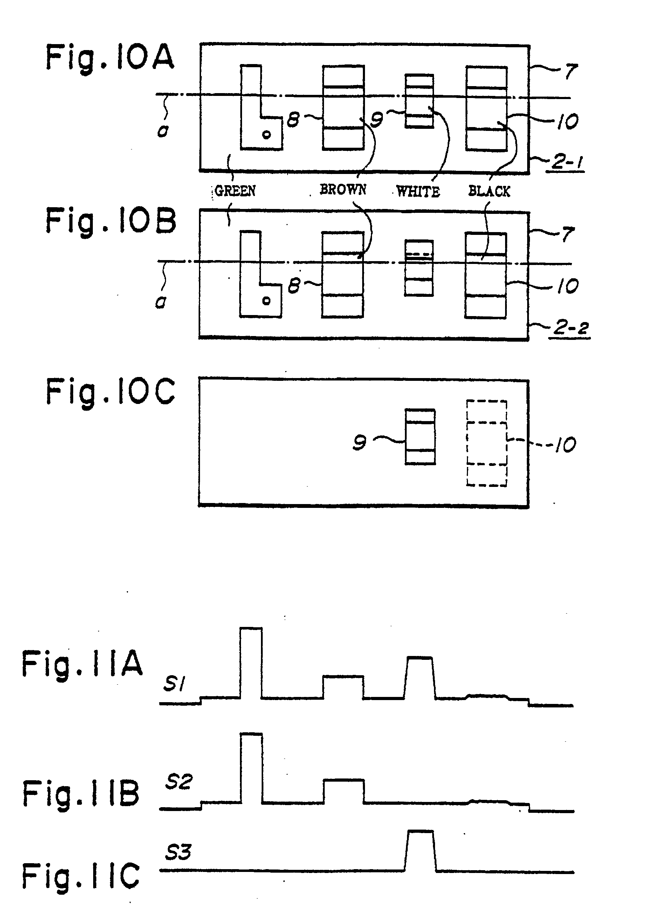

Now, referring to the exemplary printed circuit boards and so on shown in Fig. 10, the TV camera 3 takes the picture of a printed circuit board consisting, for instance, of a green base circuit board 7 mounted with a brown component part 8, a white component part 9 and a black component part 10 as shown in Figure 10(A), serving as a reference printed circuit board 2-1, and the memory unit 4 stores the picture image of this reference printed circuit board 2-1. If the TV camera 3 takes the picture of a printed circuit board having a component part arrangement different from that of this reference printed circuit board 2-1, for instance, a subject printed circuit board 2-2 with the white component part 9 missing as shown in Figure 10-(B), there will be a disagreement between the video signal S2 of the scan line "a" outputted from the TV camera 3 as shown in Figure 11(B) and the video signal S1 of the scan line "s" outputted from the memory unit 4 as shown in Figure 11(A), and the determination circuit 5, upon detecting this disagreement, supplies a difference signal S3 as shown in Figure 11(C) to the display device 6, so that the missing component part 9 is indicated on the display device 6, as shown in Figure 10(C).

However, according to such a type of automatic printed circuit board assembly inspection apparatus, if there is any component part having a similar color to that of the bare printed circuit board, for instance if a black component part 10 is mounted on a green bare printed circuit board 7 as shown in Figures 10(A) and 10(B), the difference between the signal levels of the signal S1 and S2 at the part corresponding to the bare green bare circuit board 7 and the part corresponding to the black component part 10 becomes so small that it may not be possible to detect the omission or the misplacement of such a component part 10.

## SUMMARY OF THE INVENTION

In view of such problems of devices that might be conceived of in other devices and methods addressed to this type of application (none of which however is it intended to admit as prior art to the present application except as otherwise in any case mandated by applicable law), a basic object of the present invention is to provide a method of inspecting a printed circuit board mounted with component parts which can detect omission and misplacement of a component part even when the color of the component part at fault is similar to that of the bare printed circuit board, if the color of the component part differs from that of the blank circuit board on which the component part is mounted.

This object is accomplished by a method according to claim 1 or 2.

Advantageous developments of the invention are the subject-matters of the dependent claims.

## BRIEF DESCRIPTION OF THE DRAWINGS

The present invention will now be described with respect to the preferred embodiments thereof, and with reference to the illustrative drawings appended hereto, which however are provided for the purposes of explanation and exemplification only, and are not intended to be limitative of the scope of the present invention in any way, since this scope is to be delimited solely by the accompanying claims. With relation to the figures, spatial terms are to be understood as referring only to the orientation on the drawing paper of the illustrations of the relevant parts, unless otherwise specified; like reference numerals, unless otherwise so specified, denote the same parts and gaps and spaces and flow chart steps and so on in the various figures relating to one preferred embodiment, and like parts and gaps and spaces and flow chart steps and so on in figures relating to different preferred embodiments; and:

Fig. 1 is a schematic block diagram of an apparatus for automatic inspection of printed circuit board assemblies which serves for the practice of the first preferred embodiment of the method for inspecting a printed circuit board assembly of the present invention;

Fig. 2 is a plan view of an exemplary reference printed circuit board assembly, used in said practice of the first preferred embodiment of the present invention;

Fig. 3(A) is a flow chart for illustrating the operation of said first preferred embodiment of the method for inspecting a printed circuit board assembly of the present invention, during the so called teaching phase thereof;

Fig. 3(B) is a flow chart for illustrating the operation of said first preferred embodiment of the method for inspecting a printed circuit board assembly of the present invention, during the so called inspection phase thereof;

Fig. 4 is a schematic view of an exemplary window which arises during said so called teaching phase of said practice of said first preferred embodiment;

Fig. 5 is a diagram of the Munsell color system chart, for explaining the principle of another somewhat lacking method of inspecting a printed circuit board assembly, not according to the present invention;

Fig. 6 is a color chart diagram for showing the X-Y plane of a chromaticity diagram for describing the principle of the method for inspecting a printed circuit board assembly of the present invention;

Fig. 7 is a schematic view showing the values of a G-R subtraction video signal according to the method for inspecting a printed circuit board assembly of the present invention;

Fig. 8 is a color chart diagram for showing the Y-Z plane of a chromaticity diagram for describing the principle of the method for inspecting a printed circuit board assembly of the present invention;

Fig. 9 is a block diagram of a conventional type of prior art type automatic printed circuit board assembly inspection machine;

Figs. 10(A) and 10(B) are plan views of an exemplary reference printed circuit board assembly and an exemplary subject printed circuit board assembly, respectively, for describing the action of an automatic printed circuit board assembly inspection machine;

Fig. 10(C) is a schematic view of an exemplary display shown on such an automatic printed circuit board assembly inspection machine;

Figs. 11(A) through 11(C) are schematic views showing wave forms present in different portions of such an automatic printed circuit board assembly inspection machine;

Fig. 12 is a schematic view of another apparatus for automatic inspection of printed circuit board assemblies, which serves for the practice of the second preferred embodiment of the method for inspecting a printed circuit board assembly of the present invention;

Figs. 13(A), and 15(A) are plan views of component parts mounted on printed circuit boards; and:

Figs. 13(B), 14(B), and 15(B) are wave form diagrams of the outputs from a TV camera taking pictures of the printed circuit boards of Figs. 13(A), 14(A), and 15(A), respectively.

DESCRIPTION OF THE PREFERRED EMBODIMENTS

The present invention will now be described with reference to the preferred embodiments thereof, and with reference to the figures.

*General principle*

First, the working principle of the present invention will be described, before descending into the details of the various preferred embodiments.

Color is generally defined by the attributes of hue, brightness, and saturation (or chromatic value).

If a black and white TV camera is used to take the picture of the subject printed circuit board assembly which is to be inspected for defects as explained above and hereinbelow, and the levels of this black and white video signal thus obtained are evaluated, then a component part which, although being of a different color value from that of the base printed circuit board, is of the same or similar brightness, cannot be distinguished from said base printed circuit board, and problems arise with the inspection process.

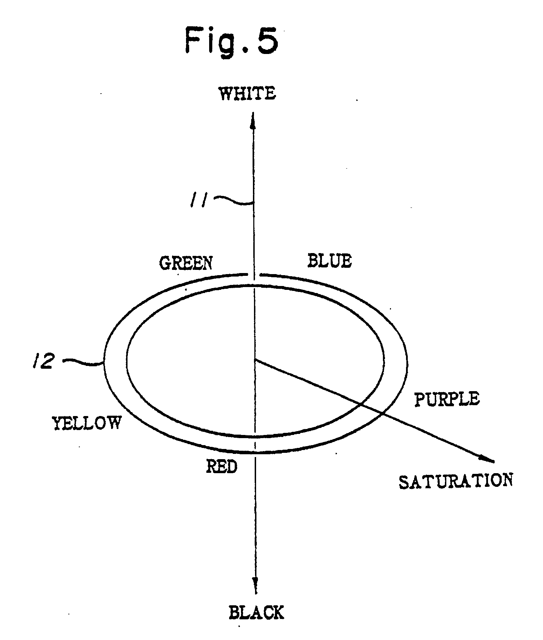

In other words, as shown in the Munsell color system chart of Fig. 5, since the colors which fall in the planes which are orthogonal to the achromatic axis 11 have the same brightness, a component part which has a color in the same such plane as the color of the base printed circuit board is mutually indistinguishable therefrom by a black and white camera, even if for example in fact the base printed circuit board is green while the component part in question is red.

It might be conceived of to take a picture of the subject printed circuit board assembly with a color TV camera and then to use only one of the R color signal, the G color signal, and the B color signal - for example to use only the R color signal - but, even in such a case, if the base printed circuit board is achromatic with the same lightness as that of a part of the R region, since they belong to the same brightness category in the Munsell color system chart, even although the color of the component part might be gray (an achromatic color having brightness, which may vary from white through to black as its sole attribute), the signal level of the part of the R color signal corresponding to the base printed circuit board in the background will be identical to and indistinguishable from the signal level of the part of said R color signal corresponding to the component part, and the problems with regard to inspection of said component part will not be satisfactorily overcome.

Therefore, when a color TV camera is used for taking the picture of the subject printed circuit board assembly, and the R color signal, the G color signal, and the B color signal indicate a certain color (for example, green if the color of the base printed circuit board in the background is green), it might be conceived of to cut the R color signal, the G color signal, and the B color signal and to extract a picture image of the component part which is of a color different from a certain color from the color picture image of the subject printed circuit board assembly, but, if the color of the component part is similar to that of the base printed circuit board, such a method will still not permit of any distinction between the two of them.

Therefore, according to the present invention, it is possible to distinguish a component part which is mounted on a base printed circuit board which is of a similar color, and thereby to detect the omission, mis-placement, mis-alignment, or mis-orientation of such a component part.

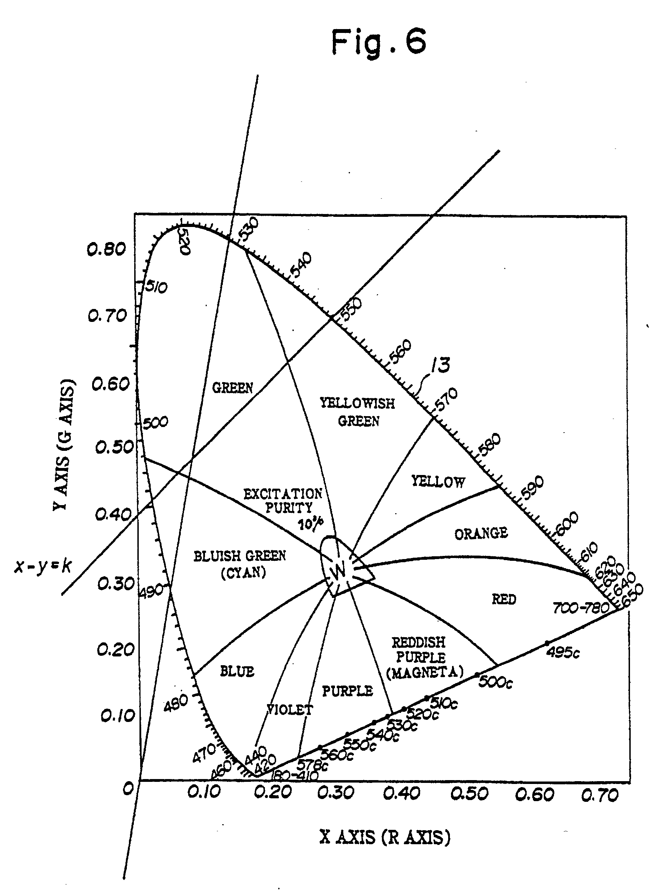

In the color chart of Fig. 6 in which the X and the Y coordinates of the XYZ color system are given, a function $X - Y = K$ can be expressed by a straight line which passes through the value K on the Y axis (corresponding to the G color signal) and intersects a spectral trajectory 13 forming an angle of 45° with respect to the X axis.

Therefore the R-G subtraction video signal which can be obtained by subtracting the G color signal from the R color signal, of the R color signal, the G color signal, and the B color signals outputted from the color TV camera, divides the spectral trajectory 13 with the function of $X - Y = 0$.

In other words, as can be seen by giving the R-G subtraction video signal on the vertical axis and the wavelength of the intersected points of the excitation purity 100% spectral trajectory 13 on the horizontal axis, the spectral trajectory is divided by the function $X - Y = 0$ into two parts which are located above and below the line expressed by this function.

If this constant K is used as a reference, it is possible to grasp the differences in hue and excitation purity by different values of the constant K. However, since the function $X - Y = K$ intersects the spectral trajectory 13 twice, extracting a certain color amounts to distinguishing the hue and the excitation purity of the region located between these two intersections.

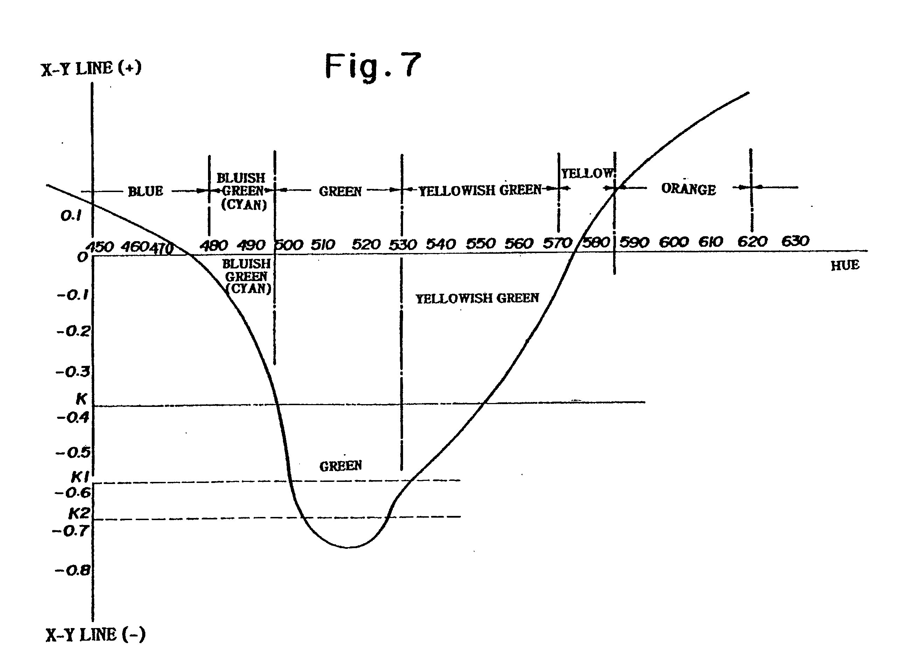

Therefore, when a color of a certain hue and a certain excitation purity is to be detected, the magnitude of the R-G subtraction video signal is determined, using the constants K1 and K2 as shown in Fig. 7.

According to the various experiments conducted by the present inventors using standard color chips, by normalizing the values of the R-G subtraction video signal obtained by subtracting the G color signal from the R color signal of a TV camera into 256 levels, it is possible to cover most of the colors (YG or yellowish green colors, G or green colors, and BG or blue green (cyan) colors of the green group into 100 levels, and to distinguish colors of more than 100 levels.

However, it goes without saying that because a color of the green group having a low excitation purity is not much different from an achromatic color and therefore is hard to be distinguished from an achromatic color, an excitation purity of a certain level is necessary.

In other words, when a circuit board which is painted in a green color of a suitable excitation purity level is used, it is possible to extract the image of a component part even when the component part is achromatic, using the R-G subtraction video signal obtained by subtracting the G or green color video signal from the R or red color video signal, unless the color of the component part is green of the same hue, brightness, and intensity.

A similar effect can be produced even when an R-alphaG subtraction video signal obtained by subtracting a constant alpha times the G or green color video signal from the R or red color video signal is used.

Similarly, it is possible to use a division video signal such as R/G or G/R using the function Y = KX. Actual experiments have confirmed that use of such a division video signal can achieve better distinguishability than use of a subtraction video signal.

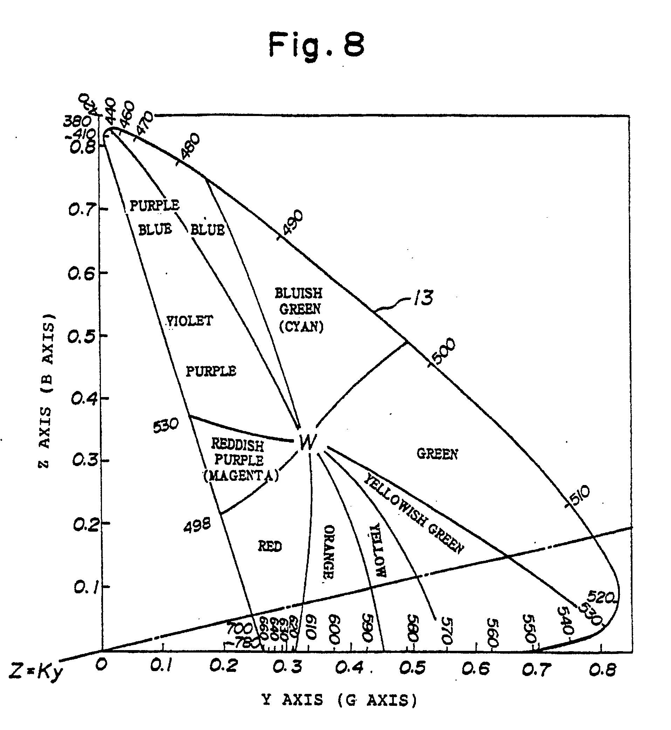

When this is expressed in terms of the Y-Z coordinates in the chromaticity diagram of the XYZ color expression system as shown in Fig. 8, it can be seen that the selective distinction of a yellow color range (YR, Y, or YG) is possible.

Likewise, other division video signals such as G/B and B/G are also provided with a high selectivity and are effective in distinguishing yellowish colors.

Other mathematical formulae such as B/-(R + G), B/(R-G), (R + G)/R, and (R-G)/R also permit distinction of colors.

It is also possible to convert two or more subtraction (or division) video signals which are obtained from different mathematical formulae into binary values corresponding to these video signals and to distinguish a color of a certain hue and excitation purity by taking a logical product of these binary values.

Now, various embodiments of the process of inspecting a subject printed circuit board assembly mounted with component parts, based upon the above described principle, will be described in the following.

## The First Preferred Embodiment

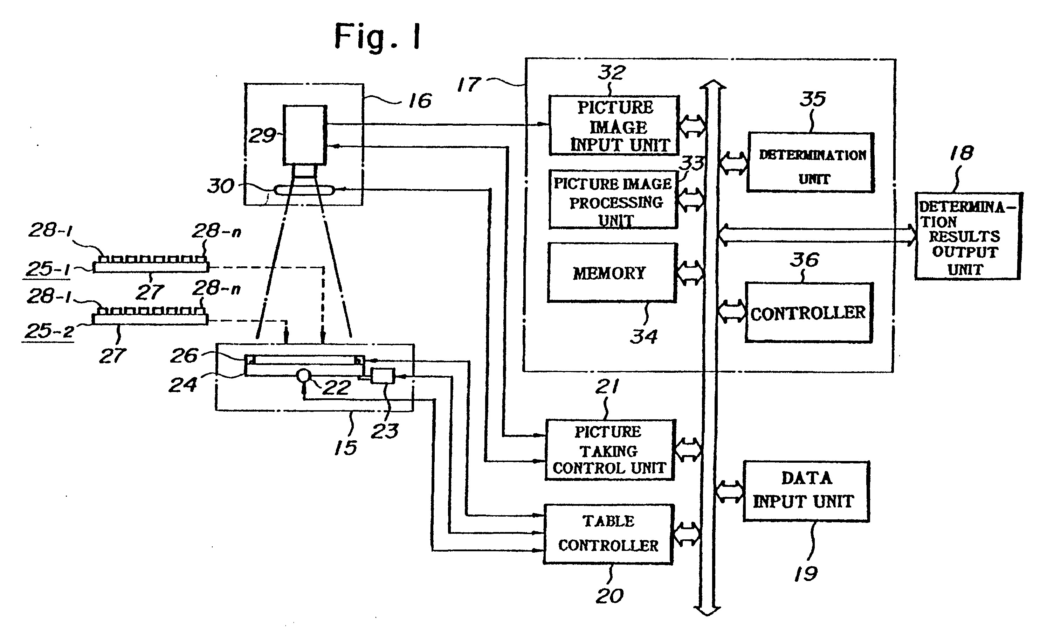

Fig. 1 is a schematic block diagram of an apparatus for automatic inspection of printed circuit board assemblies which performs the practice of the first preferred embodiment of the method for inspecting a printed circuit board assembly of the present invention.

### Construction of the apparatus

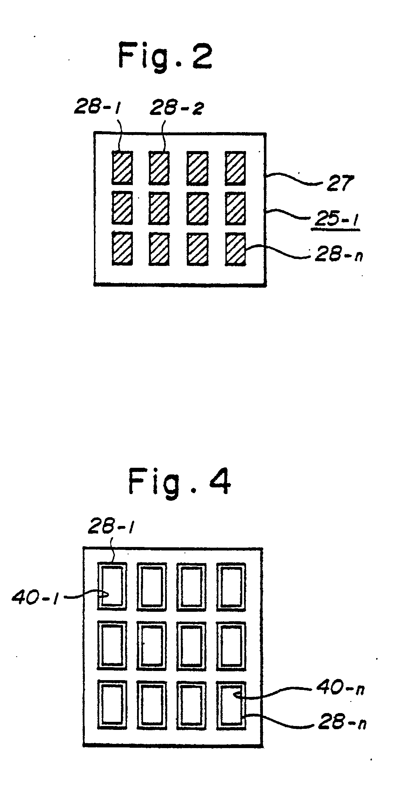

This shown apparatus for automatic inspection of printed circuit board assemblies is designed to receive a reference printed circuit board assembly 25-1 on which the distinction between the component parts thereon (designated as 28-1) and the base printed circuit board thereof (designated as 27) is particularly clear (an exemplary such reference printed circuit board assembly 25-1 is shown in Fig. 2 in plan view), and, by taking a picture image of said reference printed circuit board assembly 25-1 and processing said picture image, to input reference date relating to said reference printed circuit board assembly 25-1 for subsequently inspecting a subject printed circuit board assembly 25-2 by taking a picture thereof. And further said apparatus for automatic inspection of printed circuit board assemblies is adapted to extract component part picture images of the component parts of all colors excluding yellowish colors by obtaining a G-B subtraction signal (or a B-G subtraction signal) on a printed circuit board which is painted in a yellowish color. And this apparatus for automatic inspection of printed circuit board assemblies comprises an X-Y table unit 15, a picture taking unit 16, a processing unit 17, a determination result output unit 18, a data input unit 19, a table control unit 20, and a picture taking control unit 21.

The X-Y table unit 15 comprises a pair of pulse motors 22 and 23 which are controlled by the table control unit 20, a table 24 which is set up so as to be driven in the X and the Y directions by these pulse motors 22 and 23 respectively, and a chuck mechanism 26 for gripping and holding first the reference printed circuit board assembly 25-1 and later the subject printed circuit board assembly 25-2, said chuck mechanism 26 being mounted on the table 24. The reference printed circuit board assembly 25-1 or the subject printed circuit board assembly 25-2 is fixed with respect to the table 24 by the chuck mechanism 26 and, after said reference or said subject printed circuit board assembly 25-1 or 25-2 has been positioned in the X and the Y directions by the pulse motors 22 and 23 respectively, the picture taking unit 16 takes a picture of said reference or said subject printed circuit board assembly 25-1 or 25-2.

In this first preferred embodiment of the method for inspecting a printed circuit board assembly of the present invention, the reference printed circuit board assembly 25-1 is set up by painting the bare or blank base printed circuit board 27 yellow, by painting the side surfaces and the upper surfaces of component parts 28-1 through 28-n in some color which is not yellow or an achromatic color, and by fitting said component parts 28-1 through 28-n to said base printed circuit board 27 in appropriate numbers, positions, and orientations. Thus, when the picture taking unit 16 takes a picture of the reference printed circuit board assembly 25-1, the distinction in the resultant image between said component parts 28-1 through 28-n and said base printed circuit board 27 is very clear due to this coloring arrangement.

The subject printed circuit board assembly 25-2 is a mass produced assembly, consisting of a base printed circuit board 27 which is tinted or is painted in substantially the same way as was the base printed circuit board 27 which was utilized in the reference printed circuit board assembly 25-1, to which are fitted the same number and kinds, in the same positions and orientations and colored similarly, of component parts 28-1 through 28-n as the component parts 28-1 through 28-n which were fitted to said base printed circuit board 27 of said reference printed circuit board assembly 25-1. And, during the inspection process performed according to the first preferred embodiment of the method for inspecting a printed circuit board assembly of the present invention by the apparatus for automatic inspection of printed circuit board assemblies shown in Fig. 1, the acceptability of each subject printed circuit board assembly 25-2 in turn is determined by comparing it with the reference printed circuit board assembly 25-1.

The picture taking unit 16 is mounted above the X-Y table unit 15, and comprises a TV camera 29 which is controlled by a control signal outputted from the picture taking control unit 21 so as to be properly focused and so as to provide a proper and appropriate magnification factor and sensitivity. And a ring type illumination device 30 is coaxially placed relative to this TV camera 29 and is controlled by a control signal which is outputted from the picture taking control unit 21, so as to provide an illumination level of proper and appropriate brightness. The color picture signal outputted by the TV camera 29, which is a color analog signal of the RGB type, is supplied to the processing unit 17.

First, in the so called teaching mode when the reference printed circuit board assembly 25-1 is mounted on the table 24 by the chuck mechanism 26, the processing unit 17 produces a G-B subtraction video signal from the RGB color picture signal (corresponding to the color picture image of the reference printed circuit board assembly 25-1) which is supplied from the picture taking unit 16, and extracts therefrom the data relating to the positions and the shapes of the component parts 28-1 through 28-n and stores this data as reference parameters, i.e. as part of the reference data relating to the characteristics of the component parts as well as the sequence of the processing, according to the G-B subtraction video signal. Subsequently, in the so called inspection mode when the subject printed circuit board assembly 25-2 is mounted on said table 24 by said chuck mechanism 26, the processing unit 17 similarly produces a G-B subtraction video signal from the RGB color picture signal (corresponding to the color picture image of the subject printed circuit board assembly 25-2) which is supplied from the picture taking unit 16, and extracts therefrom the data (the inspection data) relating to the positions and the shapes of the component parts 28-1 through 28-n, and compares this inspection data with the reference data for determining the acceptability of the subject printed circuit board assembly 25-2 according to the sequence of processing, again according to the G-B subtraction video signal. The processing unit 17 comprises a picture image input unit 32, a picture image processing unit 33, a memory 34, a determination unit 35, and a control unit 36.

The picture image input unit 32 prepares the RGB color picture image signals of the reference printed circuit board assembly 25-1 or the subject printed circuit board assembly 25-2 by analog to digital conversion of the picture image signal supplied from the picture taking unit 16 and by conducting various correction processes such as shading correction and so on or the like, and the thus obtained RGB color picture image data relating to said reference printed circuit board assembly 25-1 or said subject printed circuit board assembly 25-2 is supplied to the control unit 36.

The picture image processing unit 33 produces a G-B subtraction video signal form the RGB color picture signals which it receives from the control unit 36, and extracts various parameters, such as the areas, the shapes, the positions, and the colors, of the component parts 28-1 through 28-n which are mounted on the reference printed circuit board assembly 25-1 or the subject printed circuit board assembly 25-2 by processing the picture image data supplied from the control unit 36 according to a predetermined processing sequence or a processing sequence inputted from the data input unit 19, and by distinguishing the colors of the component parts 28-1 through 28-n and the color of the base printed circuit board 27. And the obtained parameters relating to said reference printed circuit board assembly 25-1 or said subject printed circuit board assembly 25-2 are supplied to the control unit 36.

And the characteristic parameters of the component parts 28-1 through 28-n may be such parameters as the overall sum of the pixels obtained by processing the picture images of these component parts 28-1 through 28-n obtained as a G-B subtraction video signal from a window (data collection window) for each of these component parts 28-1 through 28-n according to a predetermined processing sequence, an average value which is obtained by dividing the overall sum by the total number of the pixels, and so on which are used for determining any omissions or misplacements of said component parts 28-1 through 28-n.

The memory 34 stores the parameters (reference parameters) of the component parts 28-1 through 28-n which are mounted to the reference printed circuit board assembly 25-1, window information relating thereto, and the processing sequence, as and when they are supplied from the control unit 36, and supplies these reference parameters and so on to the picture image processing unit 33 and the determination unit 35 when such a transfer is commanded by the control unit 36.

In the inspection mode, when the subject printed circuit board assembly 25-2 is mounted to the table 24 by the chuck mechanism 26, the determination unit 35 determines whether or not any one of the component parts 28-1 through 28-n is missing or is mis-positioned on the base printed circuit board 27 of said subject printed circuit board assembly 25-2, by comparing the reference parameters outputted from the memory 34 by way of the control unit 36 with the parameters (the inspection parameters of said subject printed circuit board assembly 25-2), and the results of this determination are outputted to the control unit 36.

This control unit 36 controls the picture image input unit 32, the picture image processing unit 33, the memory 34, and the determination unit 35 of the processing unit 17 so that they function either in the teaching mode or in the inspection mode.

The determination results output unit 18 comprises a CRT, a printer, and so on, and displays and prints out the reference parameters, the inspection parameters, the RGB color picture image data of the reference printed circuit board assembly 25-1 or the subject printed circuit board assembly 25-2, and the determination results, when such are supplied from the control unit 36.

The data input unit 19 comprises a keyboard and a mouse for inputting data relating to the type of the reference printed circuit board assembly 25-1 (such as the serial number of the base printed circuit board 27 thereof) and the kinds, the numbers, and the characteristics of the component parts 28-1 through 28-n which are mounted on said reference printed circuit board assembly 25-1 and the information relating to the inputting of data such as processing sequences, and said data input unit 19 may optionally be additionally provided with a monitor and a printer for confirming the inputted data and the information related to said inputting of the data. The data and the information related to the inputting of the data which are inputted from this data input unit 19 are supplied to the control unit 36.

The table control unit 20, which comprises an interface for the control unit 36 and the X-Y table unit 15, supplies the data obtained from the X-Y table unit 15 to the control unit 36 on the one hand and also controls said X-Y table unit 15 according to a control signal which said table control unit 20 receives from the control unit 36.

And the picture taking control unit 21, which comprises an interface for the control unit 36 and the picture taking unit 16, controls said picture taking unit 16 according to a control signal which said picture taking control unit 21 receives from the control unit 36.

## Operation in The Teaching Mode

Next, the operation of this apparatus for automatic inspection of printed circuit board assemblies according to the first preferred embodiment of the method for inspecting a printed circuit board assembly of the present invention, in the initial so called teaching mode, will be explained.

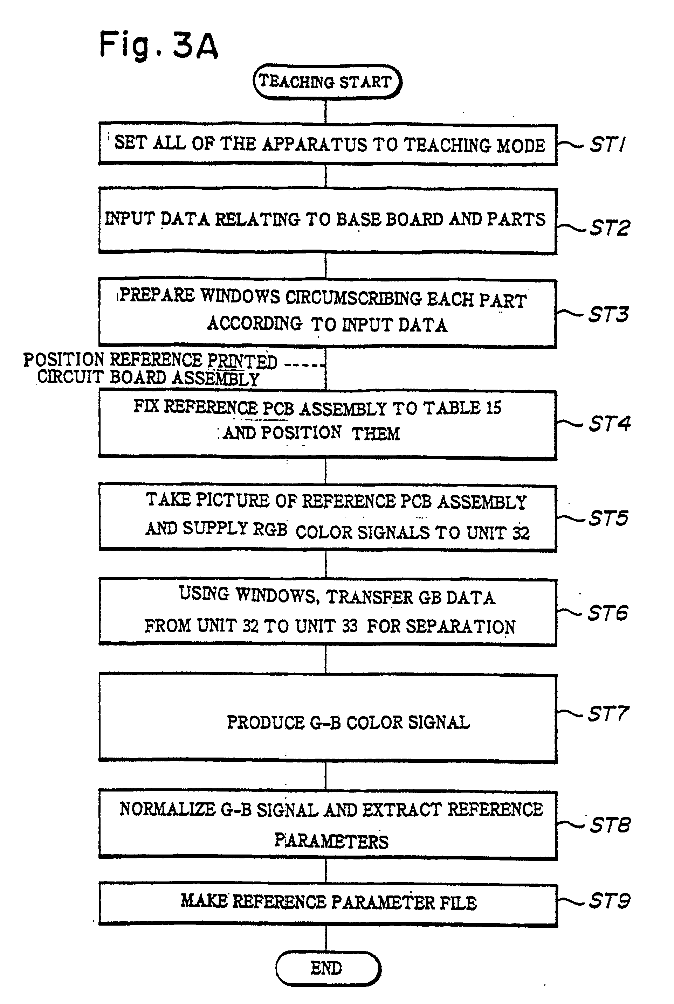

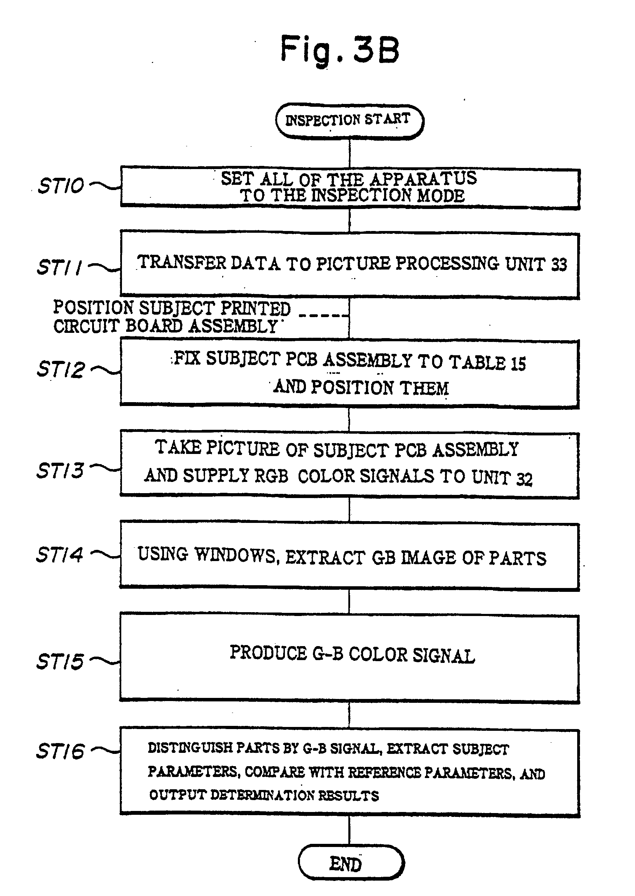

First, to initiate this so called teaching mode, which will be explained with regard to the flow charts shown in Figs. 3(A) and 3(B), in the first step ST1 of the Fig. 3(A) flow chart the control unit 36 sets the rest of the apparatus to the teaching mode; and then the flow of control passes next to the next step ST2.

In this next step ST2, the control unit 36 inputs via the data input unit 19 the data concerning the type of the reference printed circuit board assembly 25-1, data concerning the kinds, positions, shapes, and so on of the various component parts 28-1 through 28-n fitted to said reference printed circuit board assembly 25-1, and data concerning the processing sequence, and this data is stored in the memory 34; and then the flow of control passes next to the next step ST3.

In this next step ST3, the control unit 36 prepares windows 40-1 through 40-n (see Fig. 4) which circumscribe the edges of the corresponding component parts 28-1 through 28-n according to the data concerning these positions and shapes. This window information is also stored in the memory 34. And then the flow of control passes next to the next step ST4.

Next, in this next step ST4, the reference printed circuit board assembly 25-1 is placed on the table 24 of the X-Y table unit 15 by an operator or the like, and the control unit 36 activates the chuck mechanism 26 so as to fix said reference printed circuit board assembly 25-1 to said table 24 of said X-Y table unit 15, and then said control unit 36 actuates the pulse motors 22 and 23 so as to suitably position said reference printed circuit board assembly 25-1 along the X and the Y directions, while at the same time controlling the brightness of the illumination provided by the ring type illumination device 30 and simultaneously controlling the various operational parameters of the TV camera 29. And then the flow of control passes next to the step ST5.

Next, in this step ST5, the control unit 36 commands the TV camera 29 to take a picture of the reference printed circuit board assembly 25-1, and supplies the RGB color signals produced as a view of said reference printed circuit board assembly 25-1 to the picture image input unit 32, so that the RGB color picture image data may be prepared thereby.

In the next step ST6, the control unit 36 transfers the data on the window information and the processing sequence from the memory 34 to the picture image processing unit 33, and transfers the RGB color picture image data obtained by the picture image unit 32 to the picture image processing unit 33, so that the images of the component parts 28-1 through 28-n in color may be extracted by separating the RGB color picture images of the different component parts from the RGB color picture image data, using the windows 40-1 through 40-n which are determined by the window information; and then the flow of control passes next to the next step ST7.

In this next step ST7, the control unit 36 commands the picture processing unit 33 to subtract the B or blue color signal from the G or green color signal which makes up the image of the component parts 28-1 through 28-n in color, thus producing the G-B subtraction video signal; and then the flow of control passes next to the next step ST8.

In the next step ST8, the control unit 36 commands the picture image processing unit 33 to normalize the G-B subtraction signal into 256 levels for distinguishing the colors of the component parts 28-1 through 28-n from the color of the base printed circuit board 27, to extract the characteristic parameters (the reference parameters) of the component parts 28-1 through 28-n, and then the flow of control passes next to the next step ST9.

In the next step ST9, there is produced a reference parameter file which lists the values and the kinds of the reference parameters; this file is stored in the memory 34. And then the flow of control passes next to leave this flow chart, without doing anything further.

This completes the description of the operation of this apparatus for automatic inspection of printed circuit board assemblies according to the first preferred embodiment of the method for inspecting a printed circuit board assembly of the present invention, in the initial so called teaching mode.

### Operation in The Inspection Mode

Next, the operation of this apparatus for automatic inspection of printed circuit board assemblies according to the first preferred embodiment of the method for inspecting a printed circuit board assembly of the present invention, in the subsequent so called inspection mode, will be explained.

First, to initiate this so called inspection mode, in the step ST10 of the Fig. 3(B) flow chart, the control unit 36 sets the rest of the apparatus to the inspection mode; and then the flow of control passes next to the next step ST11.

In this next step ST11, the control unit 36 transfers the data on the kinds of reference parameters listed in the reference parameter file which is stored in the memory 34, and the data on the processing sequence and the window information which are also stored in the memory 34, to the picture processing unit 33, and transfers the values of the reference parameters in the reference parameter file to the determination unit 35; and then the flow of control passes next to the next step ST12.

Just before this next the step ST12, the subject printed circuit board assembly 25-2 is placed on the table 24 of the X-Y table unit 15 by an operator or the like.

Next, in the step ST12, the control unit 36 activates the chuck mechanism 26 so as to fix said subject printed circuit board assembly 25-2 to said table 24 of said X-Y table unit 15, and then said control unit 36 actuates the pulse motors 22 and 23 so as to suitably position said subject printed circuit board assembly 25-2 along the X and the Y directions, while at the same time controlling the brightness of the illumination provided by the ring type illumination device 30 and simultaneously controlling the various operational parameters of the TV camera 29. Then the flow of control next passes to the next step ST13.

In this step ST13, the control unit 36 commands the TV camera 29 to take a picture of the subject printed circuit board assembly 25-2, and supplies the RGB color picture image signal of the subject printed circuit board assembly 25-2 obtained by said TV camera 29 to the picture image input unit 32 which then produces the RGB color picture image data. And then the flow of control passes next to the next step ST14.

In the next step ST14, the control unit 36 transfers the RGB color picture image data obtained by the picture image input unit 32 to the picture image processing unit 33 and extracts the GB color picture image of the component parts 28-1 through 28-n from the RGB color picture image data by using the windows 40-1 through 40-n characterized by the window information; and then the flow of control passes next to the next step ST15.

In this next step ST15, the control unit 36 commands the picture image processing unit 33 to subtract the B color signal from the G color signal which make up the color picture image of the component parts 28-1 through 28-n, and produces the G-B subtraction video signal; and then the flow of control passes next to the next step ST16.

In this next and final step ST16, the control unit 36 commands the picture processing unit 33 to distinguish the colors of the component parts 28-1 through 28-n from the color of the base printed circuit board 27 in terms of the G-B subtraction video signal and to extract the characteristic parameters (the subject parameters) of the component parts 28-1 through 28-n according to the processing sequence and the kinds of the characteristic parameters. These characteristic parameters are then supplied to the determination unit 35 and are compared with the reference parameters. From the results of this comparison, said determination unit 35 checks as to whether or not all of the component parts 28-1 through 28-n are present or not, and whether or not there is any misplaced or misoriented component part 28-1 through 28-n, and supplies the results of this determination to the output unit 18, which displays and prints this information in an appropriate manner. And then the flow of control passes next to exit this procedure, without doing anything further.

This completes the description of the operation of this apparatus for automatic inspection of printed circuit board assemblies according to the first preferred embodiment of the method for inspecting a printed circuit board assembly of the present invention, in the later so called inspecting mode.

### Summary of the First Preferred embodiment

Although, according to the above described first preferred embodiment of the method for inspecting a printed circuit board assembly of the present invention, the processing of the picture images was conducted by the picture image processing unit 33, and the determination process relating to the parameters was performed by the determination unit 35, in another possible embodiment it would be practicable for these functions to be performed by a program which was obeyed by the control unit 36.

According to the above described first preferred embodiment of the present invention, the data on the positions and the shapes of the component parts 28-1 through 28-n were inputted via the data input unit 19, but alternatively said data could be inputted by taking a picture of a printed circuit board assembly having a black base printed circuit board and white component parts, for teaching purposes, with a color TV camera.

Also, according to the above described first preferred embodiment of the present invention, the characteristic parameters were extracted directly from the reference printed circuit board assembly 25-1 during the teaching process, but it would also be possible to extract the effective characteristic parameters by comparing the G-B subtraction video signals obtained by taking, with the TV camera 29, a picture of the blank circuit board 27 before the component parts 28-1 to 28-n are mounted thereon and of the reference printed circuit board 25-1 on which the component parts 28-1 to 28-n are mounted.

In this case, if the process of finding the effective parameters is multi layered and the effective characteristic parameters are determined for each of the component parts 28-1 to 28-n, the process may be speeded up.

Although the color of the base printed circuit board 27 was yellow in the above described first preferred embodiment, the color of this base printed circuit board 27 may be any other color when a fluorescent agent is mixed in the preflux, cream solder and so on, as long as the color emitted from the fluorescent agent and the colors of the component parts 28-1 to 28-n are distinguishable one from the other.

And, although the color of the base printed circuit board 27 was yellow in the above described embodiment, the component parts 28-1 to 28-n may be yellow instead.

When the color of the base printed circuit board 27 is green or the color of the component parts is green, the R-G subtraction video signal is used instead of the G-B subtraction video signal.

Thus, according to the present invention, as long as the color of the component parts is different from the color of the base printed circuit board, even when these colors are similar, omission or mis-placement or mis-alignment or mis-orientation of these component parts can be detected.

It is possible to tint the base printed circuit board 27 and the component parts 28-1 to 28-n in green or red color and in such a case a R-G or G-R subtraction video signal or a R/G or G/R division video signal will be used.

Although the color picture images of the reference printed circuit board 25-1 and the subject printed circuit board 25-2 were in the disclosed first preferred embodiment of the present invention specified as being taken by a color TV camera 29, in fact, as an alternative, as can be easily conceived from the working principle of the color TV camera 29, it is also possible to take the pictures of the reference printed circuit board 25-1 and the subject printed circuit board 25-2 with a monochromatic TV camera using a R color filter, a G color filter and a B color filter selectively interposed therebetween in a sequential manner and to obtain the color picture images of the reference printed circuit board 25-1 and the subject printed circuit board 25-2 in a time divided or time shared manner.

## The Second Preferred Embodiment

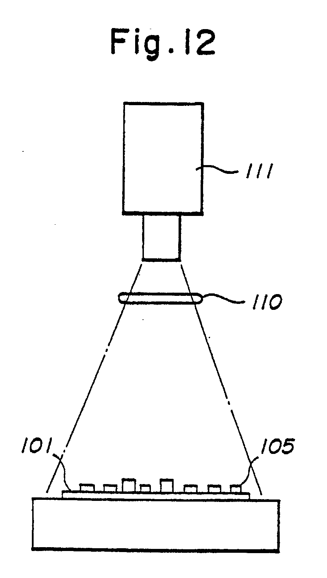

Figs. 12 through 15 relate to the second preferred embodiment of the method for inspecting a printed circuit board assembly of the present invention; and, in detail, Fig. 12 shows a schematic view of another apparatus for automatic inspection of printed circuit board assemblies, which serves for the practice of the second preferred embodiment of the method for inspecting a printed circuit board assembly of the present invention. This apparatus is shown as inspecting a printed circuit board 101, and comprises a light source 110 and a color TV camera 111 for taking the picture of the printed circuit board 101.

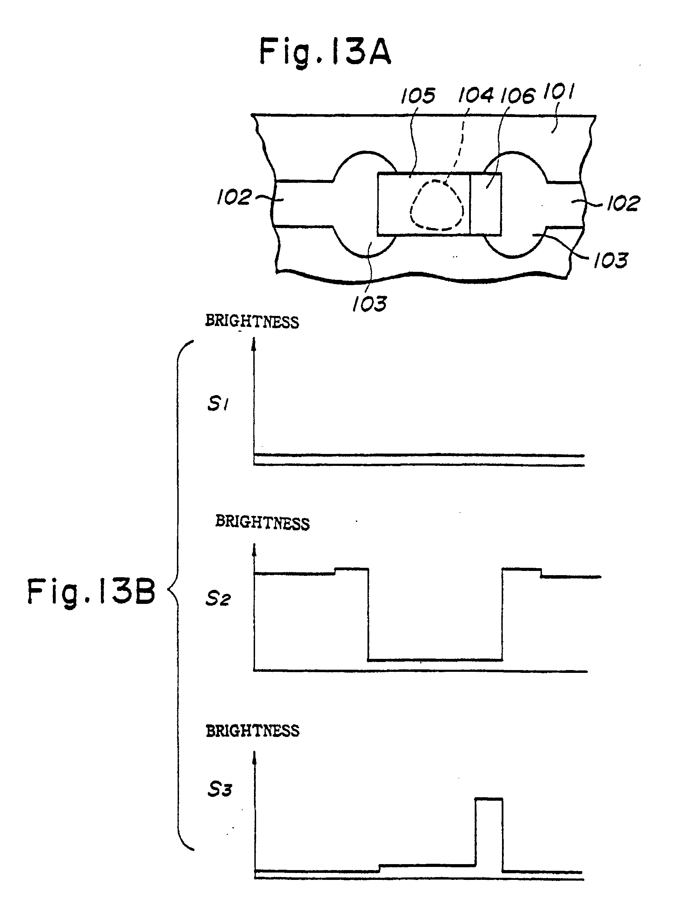

The circuit board 101 is coated with preflux which is mixed with green fluorescent material, and lands 103 are formed at ends of conductive lines 102, as shown in Figure 13(A). A bonding agent 104 mixed with red fluorescent material is coated over the region of the circuit board located between the lands 103 where a component part is to be mounted.

The light emitted from the light source 110 can range from ultraviolet light to visible blue light, or from 300 to 430 nanometers in wave length.

Inspection for any exuding or oozing out of the bonding agent, omission of a component part, misplacement of a component part, inversion of a component part, or mounting of a wrong component part on the circuit board 101 can be conducted by radiating the light from the light source 110 (for instance ultraviolet light) to excite the fluorescent agent into emitting light, and by obtaining the output signals S1, S2 and S3 corresponding to red, green and blue of the picture image as taken by a color TV camera 111.

Thus, it is possible to distinguish the bonding agent 104 with the output signal S1 corresponding to the red picture image, the background region of the printed circuit board 101 which is not occupied by a component part with the output signal S2 corresponding to the green picture image, and the component part region or the polarity indication 106 and a marking on the component part 105 with the output signal S3 corresponding to the blue picture image.

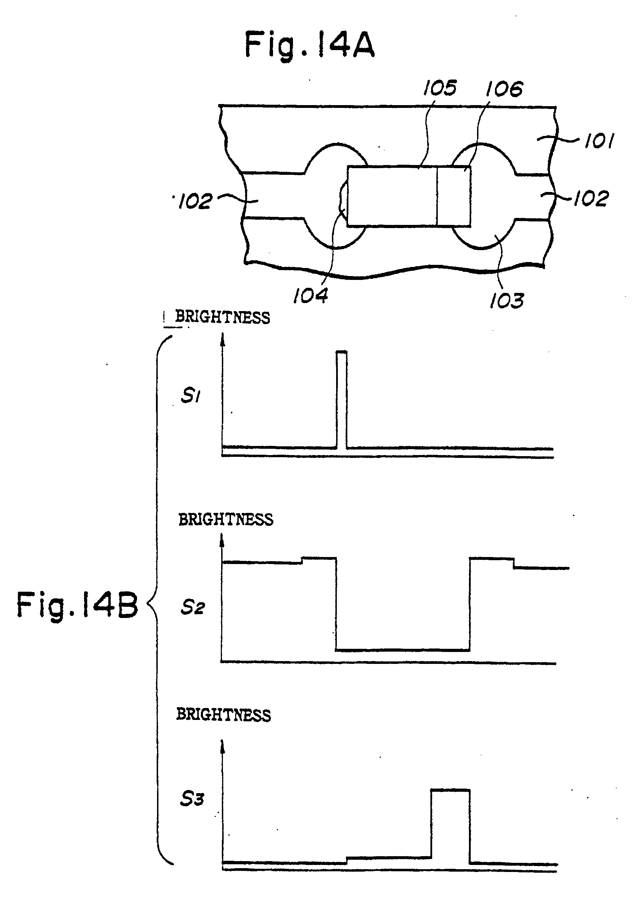

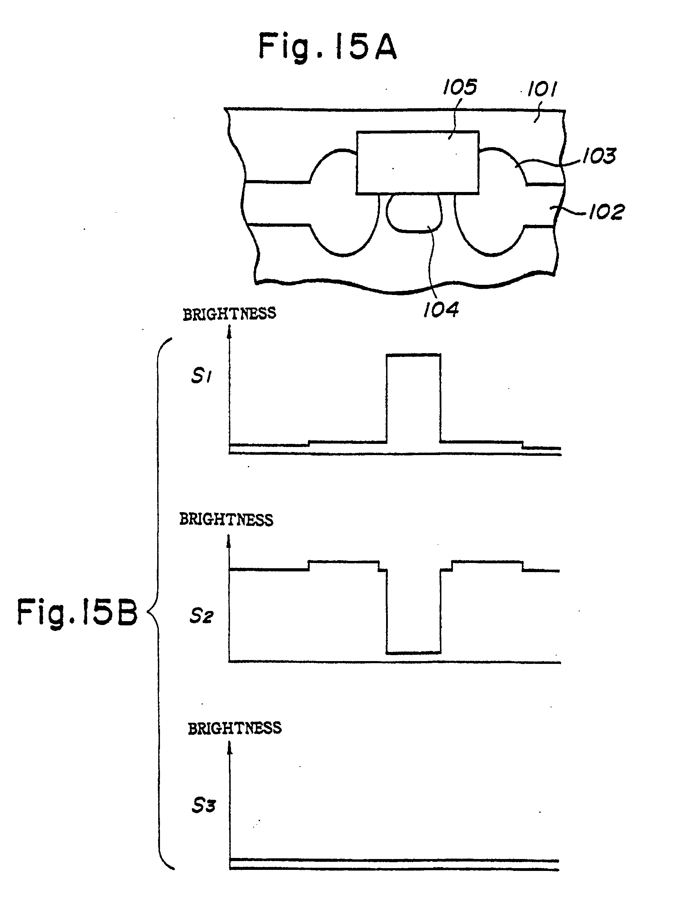

For instance, Figure 13A shows a component part 105 properly mounted on the printed circuit board 101 and the wave forms of Figure 13B indicate that the bonding agent 104 has not oozed out from the component part because the wave form level of the red output signal S1 which indicates the bonding agent 104 is low. On the other hand, Figure 14A shows the case wherein some of the bonding agent 104 has oozed out from the component part 105, and the wave forms of Figure 14B indicate that bonding agent 104 has not oozed out into the land 103 because the wave form level of the red output signal S1 in that region is high while the wave form level of the green output signal which indicates the land 103 is low. When a component part 105 is shifted from a proper location, the waveform level of the red output signal S1 between the lands 103 becomes high as shown in Figs. 15A and 15B.

## Claims

1. A method for inspection of printed circuit board assemblies each of which comprises component parts mounted on a base printed circuit board, making a distinction between parts of said base printed circuit board not occupied by said component parts and said component parts including the step of comparing an image of a subject printed circuit board assembly with an image of a reference printed circuit board assembly for determining whether or not agreement exists therebetween, characterized by making different images in basic colours of a printed circuit board assembly and by forming the difference of two of the signal levels of the basic colour signals red, green and blue before executing the comparison step.

2. A method for inspection of printed circuit board assemblies each of which comprises component parts mounted on a base printed circuit board, making a distinction between parts of said base printed circuit board not occupied by said component parts and said component parts including the step of comparing an image of a subject printed circuit board assembly with an image of a reference printed circuit board assembly for determining whether or not agreement exists therebetween, characterized by making different images in basic colours of a printed circuit board assembly and by forming the quotient of two of the signal levels of the basic colour signals red, green and blue before executing the comparison step.

3. A method for inspection of printed circuit board assemblies according to claim 2, wherein the numerator or denominator of the quotient is composed of the sum or the difference of two of said signal levels.

4. A method for inspection of printed circuit board assemblies according to anyone of the claims, wherein said base printed circuit board and said component parts are tinted in a color of a category selected from the group consisting of the green category, the red category, and the yellow category.

5. A method for inspection of printed circuit board assemblies according to claim 4, wherein said color category is the yellow category.

6. A method for inspection of printed circuit board assemblies according to claim 4, wherein said color category is the red category.

7. A method for inspection of printed circuit board assemblies according to claim 4, wherein said color category is the green category.

8. A method for inspection of printed circuit board assemblies according to claim 4, wherein said base printed circuit board is coated with a preflux mixed with a fluorescent agent.

9. A method for inspection of printed circuit board assemblies according to claim 8, wherein said fluorescent agent is green.

10. A method for inspection of printed circuit board assemblies according to claim 4, wherein said base printed circuit board is coated with a bonding agent mixed with a fluorescent agent.

11. A method for inspection of printed circuit board assemblies according to claim 10, wherein said fluorescent agent is green.

12. A method for inspection of printed circuit board assemblies according to anyone of claims 4, 8, 9, 10, and 11, wherein illumination is provided by a light source the wavelength of which varies from visible blue to ultraviolet.

13. A method for inspection of printed circuit board assemblies according to anyone of the preceding claims, wherein said color pictures are taken by a color TV camera.

**Revendications**

1. Un procédé d'inspection d'ensembles de plaques ou cartes de circuits imprimés dont chacune comprend des éléments composants montés sur une carte de circuit imprimé de base, en faisant une distinction entre des parties de ladite carte de circuit imprimé de base qui ne sont pas occupées par lesdits éléments composants et lesdits éléments composants, comprenant l'étape consistant à comparer une image d'un ensemble concerné d'une carte de circuit imprimé avec une image d'un ensemble de référence de carte de circuit imprimé pour déterminer s'il existe ou non un accord entre eux, caractérisé par la réalisation d'images différentes dans des couleurs de base d'un ensemble de cartes de circuits imprimés et par la formation de la différence de deux des niveaux de signaux des signaux de couleurs de base rouge, vert et bleu avant d'exécuter l'étape de comparaison.

2. Un procédé d'inspection d'ensembles de plaques ou cartes de circuits imprimés dont chacune comprend des éléments composants montés sur une carte de circuit imprimé de base, en faisant une distinction entre des parties de ladite carte de circuit imprimé de base qui ne sont pas occupées par lesdits éléments composants et lesdits éléments composants, comprenant l'étape consistant à comparer une image d'un ensemble concerné d'une carte de circuit imprimé avec une image d'un ensemble de référence de carte de circuit imprimé pour déterminer s'il existe ou non un accord entre eux, caractérisé par la réalisation d'images différentes dans des couleurs de base d'un ensemble de cartes de circuits imprimés et par la formation du quotient de deux des niveaux de signaux des signaux colorés de base rouge, vert et bleu avant d'exécuter l'étape de comparaison.

3. Un procédé d'inspection d'ensembles de cartes de circuits imprimés selon la revendication 2, dans lequel le numérateur ou le dénominateur du quotient est composé de la somme ou de la différence de deux desdits niveaux de signaux.

4. Un procédé d'inspection d'ensembles de cartes de circuits imprimés selon l'une quelconque des revendications précédentes, dans lequel ladite carte de circuit imprimé de base et lesdits éléments ccmposants sont teintés en une couleur d'une catégorie choisie dans le groupe constitué par la catégorie de vert, la catégorie de rouge et la catégorie de jaune.

5. Un procédé d'inspection d'ensembles de cartes de circuits imprimés selon la revendication 4, dans lequel ladite catégorie de couleur est la couleur jaune.

6. Un procédé d'inspection d'ensembles de cartes de circuits imprimés selon la revendication 4, dans lequel ladite catégorie de couleur est la catégorie rouge.

7. Un procédé d'inspection d'ensembles de cartes de circuits imprimés selon la revendication 4, dans lequel ladite catégorie de couleur est la catégorie verte.

8. Un procédé d'inspection d'ensembles de cartes de circuits imprimés selon la revendication 4 dans lequel ladite carte de circuit imprimé de base est revêtue d'un décapant préalable mélangé avec un agent fluorescent.

9. Un procédé d'inspection d'ensembles de cartes de circuits imprimés selon la revendication 8, dans lequel ledit agent fluorescent est vert.

10. Un procédé d'inspection d'ensembles de cartes de circuits imprimés selon la revendication 4, dans lequel ladite carte de circuit imprimé de base est revêtue d'un agent de liaison mélangé à un agent fluorescent.

11. Un procédé d'inspection d'ensembles de cartes de circuits imprimés selon la revendication 10, dans lequel ledit agent fluorescent est vert.

12. Un procédé d'inspection d'ensembles de cartes de circuits imprimés selon l'une quelconque des revendications 4, 8, 9, 10 et 11, dans lequel un éclairage est réalisé par une source lumineuse dont la longueur d'onde varie du bleu visible à l'ultra-violet.

13. Un procédé d'inspection d'ensembles de cartes de circuits imprimés selon l'une quelconque des revendications précédentes dans lequel lesdites images en couleur sont prises par une caméra de télévision couleur.

**Patentansprüche**

1. Verfahren zur Inspektion von Leiterplattenaufbauten, von denen jeder auf einer Basisleiterplatte angebrachte Komponenten aufweist, wobei zwischen von den Komponenten nicht besetzten Teilen der Basisleiterplatte und den Komponenten unterschieden wird, mit dem Verfahrensschritt des Vergleichens eines Bildes eines Gegenstandsleiterplattenaufbaus mit einem Bild eines Referenzleiterplattenaufbaus zur Bestimmung, ob Übereinstimmung zwischen ihnen besteht oder nicht, gekennzeichnet durch das Herstellen von verschiedenen Bildern eines Leiterplattenaufbaus in Grundfarben und das Bilden der Differenz von zwei der Signalwerte der Grundfarbensignale Rot, Grün und Blau vor dem Durchführen des Vergleichsschritts.

2. Verfahren zur Inspektion von Leiterplattenaufbauten, von denen jeder auf einer Basisleiterplatte angebrachte Komponenten aufweist, wobei zwischen von den Komponenten nicht besetzten Teilen der Basisleiterplatte und den Komponenten unterschieden wird, mit dem Verfahrensschritt des Vergleichens eines Bildes eines Gegenstandsleiterplattenaufbaus mit einem Bild eines Referenzleiterplattenaufbaus zur Bestimmung, ob Übereinstimmung zwischen ihnen besteht oder nicht, gekennzeichnet durch das Herstellen von verschiedenen Bildern eines Leiterplattenaufbaus in Grundfarben und das Bilden des Quotienten von zwei der Signalwerte der Grundfarbensignale Rot, Grün und Blau vor dem Durchführen des Vergleichsschritts.

3. Verfahren zur Inspektion von Leiterplattenaufbauten nach Anspruch 2, bei welchem sich der Zähler oder Nenner des Quotienten aus der Summe oder der Differenz von zwei der Signalwerte zusammensetzt.

4. Verfahren zur Inspektion von Leiterplattenaufbauten nach irgendeinem der Ansprüche, bei welchem die Basisleiterplatte und die Komponenten in einer Farbe einer Kategorie ausgewählt aus der Gruppe, bestehend aus der grünen Kategorie, der roten Kategorie und der gelben Kategorie, gefärbt sind.

5. Verfahren zur Inspektion von Leiterplattenaufbauten nach Anspruch 4, bei welchem die Farbkategorie die gelbe Kategorie ist.

6. Verfahren zur Inspektion von Leiterplattenaufbauten nach Anspruch 4, bei welchem die Farbkategorie die rote Kategorie ist.

7. Verfahren zur Inspektion von Leiterplattenaufbauten nach Anspruch 4, bei welchem die Farbkategorie die grüne Kategorie ist.

8. Verfahren zur Inspektion von Leiterplattenaufbauten nach Anspruch 4, bei welchem die Basisleiterplatte mit einem mit einem fluoreszierendem Mittel gemischten Vorflußmittel beschichtet ist.

9. Verfahren zur Inspektion von Leiterplattenaufbauten nach Anspruch 8, bei welchem das fluoreszierende Mittel grün ist.

10. Verfahren zur Inspektion von Leiterplattenaufbauten nach Anspruch 4, bei welchem die Basisleiterplatte mit einem mit einem fluoreszierenden Mittel gemischten Klebemittel beschichtet ist.

11. Verfahren zur Inspektion von Leiterplattenaufbauten nach Anspruch 10, bei welchem das fluoreszierende Mittel grün ist.

12. Verfahren zur Inspektion von Leiterplattenaufbauten nach irgendeinem der Ansprüche 4, 8, 9, 10 und 11, bei welchem die Beleuchtung durch eine Lichtquelle, deren Wellenlänge vom sichtbaren Blau bis ultraviolett variiert, geliefert wird.

13. Verfahren zur Inspektion von Leiterplattenaufbauten nach irgendeinem der vorstehenden Ansprüche, bei welchem die Farbbilder mit einer Farbfernsehkamera aufgenommen werden.

# Fig. 1

PICTURE IMAGE INPUT UNIT *32*

PICTURE IMAGE PROCESSING UNIT *33*

MEMORY *34*

DETERMINATION UNIT *35*

CONTROLLER *36*

DETERMINATION RESULTS OUTPUT UNIT *18*

PICTURE TAKING CONTROL UNIT *21*

TABLE CONTROLLER *20*

DATA INPUT UNIT *19*

*16*

*29*

*30*

*28-1*  *28-n*

*25-1*

*27*  *28-1*  *28-n*

*28-1*

*25-2*

*27*

*26*

*24*

*22*

*23*

*15*

*17*

*15*

EP 0 231 941 B1

# Fig. 2

28-1  28-2

27

25-1

28-n

# Fig. 4

28-1

40-1

40-n

28-n

# Fig. 3A

```
                    ( TEACHING START )
                            │
┌───────────────────────────────────────────────┐
│  SET ALL OF THE APPARATUS TO TEACHING MODE     │── ST1
└───────────────────────────────────────────────┘
                            │
┌───────────────────────────────────────────────┐
│  INPUT DATA RELATING TO BASE BOARD AND PARTS   │── ST2
└───────────────────────────────────────────────┘
                            │
┌───────────────────────────────────────────────┐
│  PREPARE WINDOWS CIRCUMSCRIBING EACH PART      │── ST3
│         ACCORDING TO INPUT DATA                │
└───────────────────────────────────────────────┘

POSITION REFERENCE PRINTED ----
CIRCUIT BOARD ASSEMBLY
                            │
┌───────────────────────────────────────────────┐
│  FIX REFERENCE PCB ASSEMBLY TO TABLE 15        │── ST4
│         AND POSITION THEM                      │
└───────────────────────────────────────────────┘
                            │
┌───────────────────────────────────────────────┐
│  TAKE PICTURE OF REFERENCE PCB ASSEMBLY        │── ST5
│  AND SUPPLY RGB COLOR SIGNALS TO UNIT 32       │
└───────────────────────────────────────────────┘
                            │
┌───────────────────────────────────────────────┐
│  USING WINDOWS, TRANSFER GB DATA               │── ST6
│  FROM UNIT 32 TO UNIT 33 FOR SEPARATION        │
└───────────────────────────────────────────────┘
                            │
┌───────────────────────────────────────────────┐
│                                                │
│         PRODUCE G-B COLOR SIGNAL               │── ST7
│                                                │
└───────────────────────────────────────────────┘
                            │
┌───────────────────────────────────────────────┐
│  NORMALIZE G-B SIGNAL AND EXTRACT REFERENCE    │── ST8
│              PARAMETERS                         │
└───────────────────────────────────────────────┘
                            │
┌───────────────────────────────────────────────┐
│       MAKE REFERENCE PARAMETER FILE            │── ST9
└───────────────────────────────────────────────┘
                            │
                        (  END  )
```

# Fig. 3B

( INSPECTION START )

ST10 — | SET ALL OF THE APPARATUS
TO THE INSPECTION MODE |

ST11 — | TRANSFER DATA TO PICTURE PROCESSING UNIT 33 |

POSITION SUBJECT PRINTED
CIRCUIT BOARD ASSEMBLY

ST12 — | FIX SUBJECT PCB ASSEMBLY TO TABLE 15
AND POSITION THEM |

ST13 — | TAKE PICTURE OF SUBJECT PCB ASSEMBLY
AND SUPPLY RGB COLOR SIGNALS TO UNIT 32 |

ST14 — | USING WINDOWS, EXTRACT GB IMAGE OF PARTS |

ST15 — | PRODUCE G-B COLOR SIGNAL |

ST16 — | DISTINGUISH PARTS BY G-B SIGNAL, EXTRACT SUBJECT
PARAMETERS, COMPARE WITH REFERENCE PARAMETERS, AND
OUTPUT DETERMINATION RESULTS |

( END )

# Fig.5

WHITE

GREEN    BLUE

YELLOW

PURPLE

RED

SATURATION

BLACK

# Fig.6

# Fig. 7

# Fig. 8

# Fig. 9

EP 0 231 941 B1

Fig. I0A

GREEN    BROWN    WHITE    BLACK

Fig. I0B

Fig. I0C

Fig. IIA    S1

Fig. IIB    S2

Fig. IIC    S3

# Fig.12

# Fig.13A

# Fig.13B

# Fig.14A

# Fig.14B

# Fig.15A

# Fig.15B